# EUROPEAN PATENT APPLICATION

(11) **EP 2 498 277 A1**
(43) Date of publication of application: **12.09.2012**
(21) Application number: 09850903.7
(22) Date of filing: 02.11.2009
(51) Int. Cl.: H01L 21/205

(54) **CHEMICAL VAPOR DEPOSITION DEVICE AND TEMPERATURE CONTROL METHOD OF CHEMICAL VAPOR DEPOSITION DEVICE**

(71) Applicant: Ligadp Co., Ltd, Seongnam-si, Gyeonggi-do 462-807 (KR)
(72) Inventor: HONG, Sung Jae, Seongnam-si Gyeonggi-do 462-836 (KR)
(74) Representative: Zimmermann, Tankred Klaus
(86) International application number: PCT/KR2009/006389
(87) International publication number: WO 2011/052832

(57) **Abstract**

A method capable of perceiving a temperature difference between a susceptor surface and a wafer surface even without special complicated or high-priced equipment is needed. To accomplish such a purpose, the present invention provides a chemical vapor deposition device that comprises: a chamber; a susceptor which is positioned on the inner side of the chamber to allow rotation therein, wherein a wafer is stacked on an upper side; a gas supplier which is disposed on the inner side of the chamber, and sprays gas toward the wafer; a heater which is disposed on the inner side of the susceptor, and heats the wafer; a temperature sensor which is positioned in the chamber, and measures the temperature of the susceptor; a rotation recognition mark which is equipped at the position in which the mark is integrally rotated with the susceptor; a rotation recognition sensor which is positioned in the chamber in order to determine the rotated state of the susceptor, and detects the rotation recognition mark; and a controller which calculates the temperature distribution of the upper side of the susceptor by using the rotation recognition sensor and the temperature sensor, and controls the heater on the basis of the temperature distribution.

## Description

### BACKGROUND OF THE INVENTION

### Field of the Invention

The present invention relates to a chemical vapor deposition device and a temperature control method of the chemical vapor deposition device, which are capable of precisely controlling a temperature within a chamber by precisely measuring a temperature distribution at the upper surface of a susceptor.

### Discussion of the Related Art

A chemical vapor deposition device is used to deposit a thin film on a surface of a semiconductor wafer. A desired thin film is deposited on wafers placed in a susceptor by blowing a process gas into a chamber through gas suppliers.

In depositing the thin film, adequate internal temperature is very important because it has a great effect on the quality of the thin film. In particular, in metal organic chemical vapor deposition (MOCVD), a high efficiency light-emitting device can be obtained only when temperature control is effectively performed.

For effective temperature control, first, a temperature distribution at the top of a susceptor must be able to be precisely checked. This is because the amount of electric power to be supplied to heaters can be checked only when an accurate temperature distribution is checked.

There may be a specific temperature difference between a surface temperature in a plurality of wafers loaded into the upper surface of the susceptor and a temperature surface in the susceptor. According to the prior art, temperature control is performed by not distinguishing a temperature in the susceptor surface and a temperature in the wafer surface from each other.

In order to produce a higher-efficiency and higher-quality thin film, it is necessary to precisely perform temperature control by accurately checking a difference in the surface temperature.

There is, however, a problem in that very complicated and expensive equipment must be additionally installed in order to check the difference in the temperature.

### Summary of the Invention

There is a need for a method of accurately checking a temperature distribution at the top of a susceptor in order to produce a high efficiency and high-quality thin film.

More particularly, there is a need for a temperature control method, which is capable of distinguishing a temperature in a susceptor surface and a temperature in a wafer surface from each other and of taking the temperature difference into consideration.

Furthermore, there is a need for a method capable of checking a temperature difference between a susceptor surface and a wafer surface without additional complicated and expensive equipment.

The technical objects to be achieved by the present invention are not limited to the above-mentioned objects and other technical objects that have not been mentioned above will become evident to those skilled in the art from the following description.

To solve the problems, a chemical vapor deposition device according to the present invention includes a chamber; a susceptor rotatably placed within the chamber and configured to have wafers loaded on its upper surface; a gas supplier provided within the chamber and configured to spray gas toward the wafers; heaters provided within the susceptor and configured to heat the wafers; temperature sensors provided at the upper portion of the chamber and configured to measure a temperature at an upper surface of the susceptor; a rotation recognition mark provided to be integrally rotated along with the susceptor; a rotation recognition sensor provided in the chamber in order to determine the rotation state of the susceptor and configured to detect the rotation recognition mark; and a controller configured to calculate a temperature distribution at the upper surface of the susceptor by using the rotation recognition sensor and the temperature sensors and to control the heaters based on the temperature distribution.

Furthermore, the heaters may include a plurality of individual heaters arranged to form a concentric circle around the rotating shaft of the susceptor, and the controller may individually control the individual heaters.

Furthermore, the temperature sensor is configured to be plural in order to check a temperature distribution for different positions in the susceptor.

Furthermore, the rotation recognition mark may include at least one of a concave part, a convex part, and a reflection unit.

Furthermore, a plurality of the rotation recognition marks or the rotation recognition sensors may be radially provided around the rotating shaft of the susceptor such that a detection cycle for the rotation recognition marks is reduced.

Furthermore, the temperature distribution may be obtained by calculating a rotation angle or rotation time of the susceptor by using the rotation recognition sensor, and the temperature distribution may be an angle-based temperature distribution or an time-based temperature distribution calculated by matching the calculated rotation angle or rotation time with the measured values of the temperature sensors.

To solve the problems, the present invention provides a temperature control method of a chemical vapor deposition device, including a chamber, a susceptor rotatably placed within the chamber and configured to have wafers loaded on its upper surface, a gas sprayer provided within the chamber and configured to spray gas toward the wafers, heaters provided within the susceptor and configured to heat the wafers, temperature sensors provided at the upper portion of the chamber and configured to measure a temperature at the upper surface of the susceptor, a rotation recognition mark provided at the susceptor or the rotating shaft of the susceptor to be integrally rotated along with the susceptor, and a rotation recognition sensor provided in the chamber in order to determine the rotation state of the susceptor and configured to detect the rotation recognition mark, wherein the temperature control method includes the steps of (a) calculating a temperature distribution of the susceptor by using the rotation recognition sensor and the temperature sensors; and (b) controlling the heaters based on the temperature distribution.

Furthermore, the temperature control method may further include the step of inputting at least one of the subject of measurement, position information about the temperature sensors, position information about the rotation recognition mark, and a reference temperature to be used for temperature control, before the step (b).

Furthermore, the step (a) may include the steps of (a1) calculating a rotation angle or rotation time of the susceptor by using the rotation recognition sensor and (a2) calculating an angle-based temperature distribution or a time-based temperature distribution by matching the calculated rotation angle or rotation time with the measured values of the temperature sensors.

Furthermore, the step (b) may include classifying the temperature distribution into relatively high temperature sections and relatively low temperature sections by using a preset filtering function and controlling the heaters based on the high temperature sections or the low temperature sections.

Furthermore, the step (b) may include controlling the heaters by comparing an average temperature or a real-time temperature at a position, selected from the high temperature sections or the low temperature sections, with a preset reference temperature.

Furthermore, the step (b) may include filtering the temperature distribution by obtaining sections which an average temperature change during a preset unit time is smaller than a preset temperature change during a preset unit time from the temperature distribution and, comparing average temperatures in the filtered sections and classifying a section having higher ratio than a preset ratio as the high temperature section and a section having lower ratio than a preset ratio as the low temperature section.

Furthermore, the high temperature sections and the low temperature sections may be sections from which temperature change sections, appearing when temperature is changed at edge portions of the wafers, have been filtered.

Furthermore, a section in which an average temperature change is greater than a preset temperature change during a preset unit time may be determined as the temperature change section and the temperature change section may be filtered from the high temperature section and the low temperature section.

Furthermore, the high temperature section may be matched with a susceptor section, the low temperature section may be matched with a wafer section, and the heaters may be controlled based on the susceptor section or the wafer section selected by a user.

There is an advantage in that an actual rotation state of the susceptor can be accurately checked because the rotation recognition mark and the rotation recognition sensor are used.

Furthermore, there is an advantage in that a measured value having high reliability for an actual rotation state of the susceptor can be calculated while using a relatively simple apparatus.

The technical effects of the present invention are not limited to the above-described effects and other technical effects that have not been described will be evidently understood by those skilled in the art from the following description.

### Brief Description of the Drawings

FIG. 1 is a schematic cross-sectional view of a chemical vapor deposition device according to a first embodiment of the present invention.
FIG. 2 is a schematic cross-sectional view of a chemical vapor deposition device according to a second embodiment of the present invention.
FIG. 3 is an enlarged view of portions of a rotation recognition mark and a rotation recognition sensor.
FIG. 4 is a plan view schematically showing the operations of the rotation recognition mark and the rotation recognition sensor according to a second embodiment of the present invention.
FIG. 5 is a flowchart of a temperature control method of the chemical vapor deposition device according to the present invention.
FIG. 6 is a graph showing an example of values measured by temperature sensors according to a lapse of time.

### Detailed Description of the Embodiments

Hereinafter, embodiments of the present invention will be described in detail with reference to the accompanying drawings. However, the present invention is not limited to the disclosed embodiments, but may be implemented in various forms. The present embodiments are provided to complete the disclosure of the present invention and to allow those having ordinary skill in the art to understand the scope of the present invention. The shapes, etc., of elements in the drawings may be exaggerated in order to highlight clearer descriptions thereof. The same reference numbers are used throughout the drawings to refer to the same parts

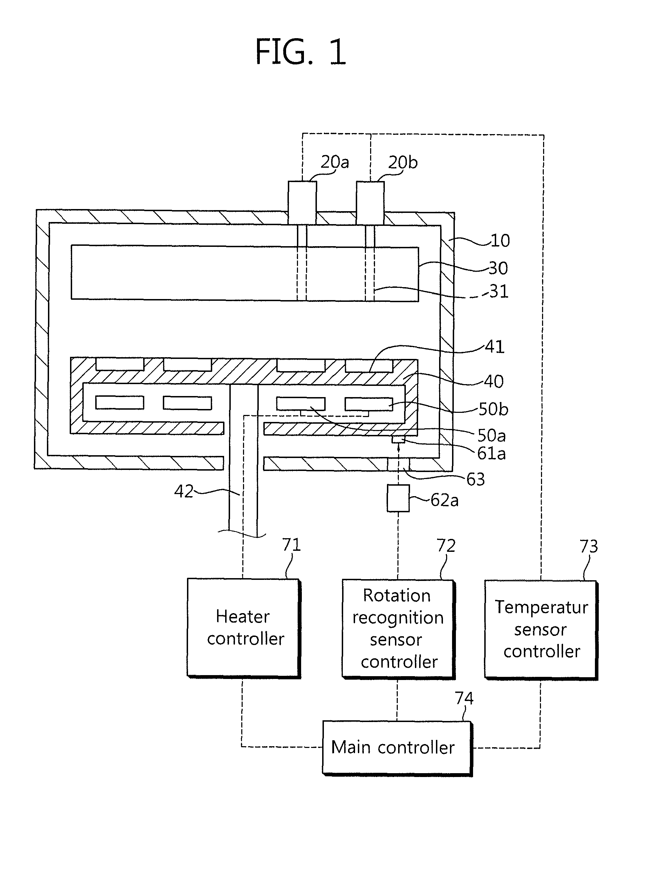

FIG. 1 is a schematic cross-sectional view of a chemical vapor deposition device according to a first embodiment of the present invention.

As shown in FIG. 1, the chemical vapor deposition device according to the present embodiment includes a chamber 10, a susceptor 40, a gas supplier 30, heaters 50a and 50b, temperature sensors 20a and 20b, a rotation recognition mark 61 a, a rotation recognition sensor 62a, a heater controller 71, a rotation recognition sensor controller 72, a temperature sensor controller 73, and a main controller 745.

If the present embodiment is applied to a metal organic chemical vapor deposition (MOCVD) device, group III gas and group V gas may be sprayed from the gas supplier 30 toward wafers loaded into respective wafer pockets 41 at the upper surface of the susceptor 40.

The temperature sensors 20a and 20b may be provided on the upper portion of the chamber 10 in order to detect a temperature at a top of the susceptor 40. Alternatively, if temperature of the wafers loaded into the susceptor can be properly measured, the temperature sensors may be placed on the side of the susceptor or at the bottom of the susceptor.

A pyrometer using reflected light from an object may be used as the temperature sensors 20a and 20b in order to measure temperature in a contactless way. For example, a pyrometer for measuring a surface temperature in the frequency of 700 Hz may be used.

Since the gas supplier 30 is provided between the temperature sensors 20a and 20b and the susceptor 40, through holes 31 may be provided within the gas supplier so that reflected light at the top of the susceptor 40 can be secured.

A plurality of the temperature sensors 20a and 20b may be arranged in a radius direction to the rotating shaft 42 of the susceptor 40. Accordingly, a temperature distribution according to the distance from the rotating shaft 42 of the susceptor 40 can be checked.

The wafers are loaded into the respective wafer pockets 41 so that thin films can be formed on their top surfaces. A plurality of the wafer pockets 41 may be provided in the top surface of the susceptor 40.

A plurality of the heaters 50a and 50b having a doughnut form may be provided within the susceptor 40 in order to heat the susceptor 40. The heater controller 71 may control the plurality of heaters 50a and 50b individually. That is, the heater controller 71 may uniformly control the temperatures of the plurality of heaters 50a and 50b, proportionally control the temperatures of the heaters 50a and 50b, and separately control a rise and fall of the temperatures of the heaters 50a and 50b.

The susceptor 40 is rotated around the rotating shaft 42 at high speed, but the heaters 50a and 50b may remain stopped.

A rotation recognition mark 61 a may be placed on the bottom of the susceptor 40, and a rotation recognition sensor 62a for detecting the rotation recognition mark 61 a may be provided at the chamber 10.

The rotation recognition mark 61a is not limited to the above position, but may be placed in other parts to be integrally rotated along with the susceptor 40. The rotation recognition mark 61a may include a concave part or a convex part, and the rotation recognition mark 61 a may be formed of a reflection unit.

Furthermore, the rotation recognition mark 61 a is not limited to a specific form, and the rotation recognition mark 61 a may have various forms or materials that can be detected by the rotation recognition sensor 62a according to the sensing method of the rotation recognition sensor 62a.

A method of detecting the rotation recognition mark may be various. For example, a method of checking whether light emitted from the rotation recognition sensor 62a has reached the rotation recognition mark 61a by checking that the light reaches the rotation recognition mark 61 a through a transparent window 63 and light reflected from the rotation recognition mark 61 a reaches the rotation recognition sensor 62a through the transparent window 63 may be used. That is, the above method is a method of detecting a change in a surface shape at the bottom of the susceptor 40.

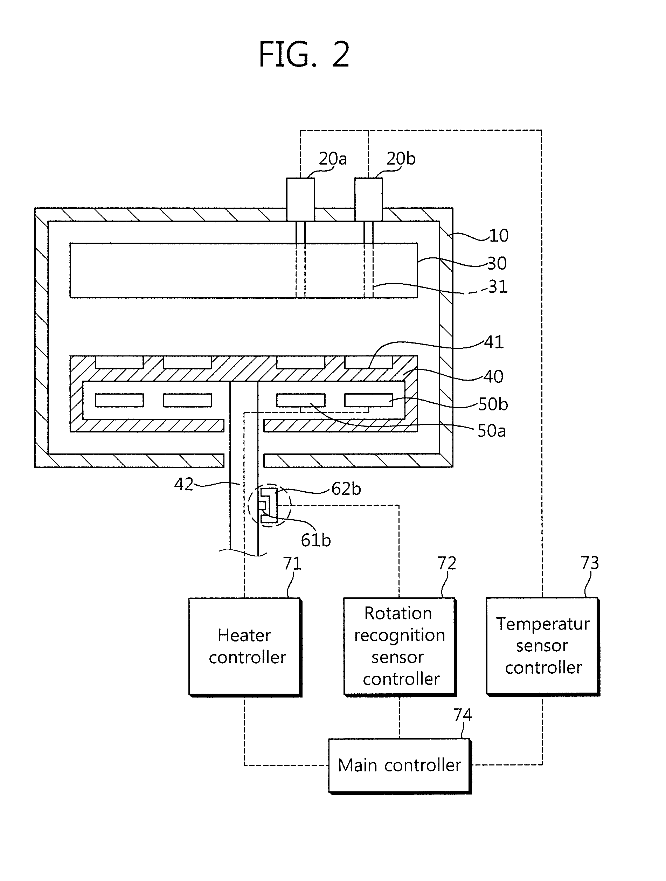

FIG. 2 is a schematic cross-sectional view showing a chemical vapor deposition device according to a second embodiment of the present invention.

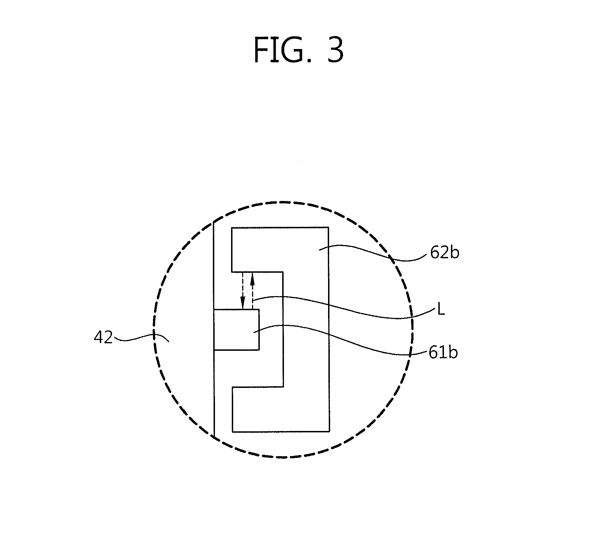

FIG. 3 is an enlarged view of portions of a rotation detection mark and a rotation detection sensor. The same reference numerals as those of the first embodiment are used to refer to similar elements of the first embodiment, for convenience of description.

As shown in FIG. 2, a rotation recognition sensor 62b may be placed near the rotating shaft 42 of the susceptor 40. A ray of light L is emitted on one side of the rotation recognition sensor 62b, and the ray of light L is detected on the other side of the rotation recognition sensor 62b. A rotation recognition mark 61 b may be placed in the rotating shaft 42 of the susceptor 40. A moment when the rotation recognition mark 61 b covers the ray of light L while passing through the rotation recognition sensor 62b can be detected by the rotation recognition sensor 62b.

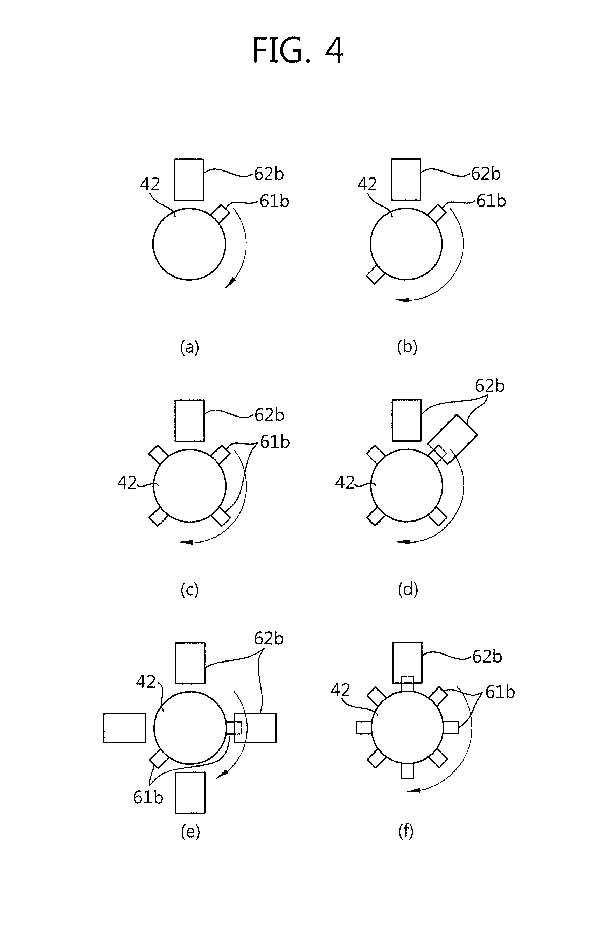

FIG. 4 is a plan view schematically showing the operations of the rotation detection mark and the rotation detection sensor according to a second embodiment of the present invention.

FIG. 4(a) corresponds to the case where the number of rotation recognition marks 61 b is one. The rotation recognition sensor 62b can detect a rotation state at every 360°. It is, however, preferred that a plurality of the rotation recognition marks be radially provided around the rotating shaft of the susceptor because the rotation state can be accurately checked according to a reduction of detection cycle for the rotation recognition marks.

FIG. 4(b) corresponds to the case where the number of rotation recognition marks 61 b is two. The rotation recognition sensor 62b can detect a rotation state at every 180°.

FIG. 4(c) corresponds to the case where the number of rotation recognition marks 61 b is four. The rotation recognition sensor 62b can detect a rotation state at every 90°.

FIG. 4(d) corresponds to the case where the number of rotation recognition marks 61 b is four and the number of rotation recognition sensors 62b is two. The rotation recognition sensors 62b can detect a rotation state at every 45°. The rotation state can be accurately detected although the rotating speed of the susceptor is a relatively low speed because a detection cycle is short as compared with the case of FIG. 4(a).

FIG. 4(e) corresponds to the case where the number of rotation recognition marks 61 b is two and the number of rotation recognition sensors 62b is four. The rotation recognition sensors 62b can detect a rotation state at every 45°.

FIG. 4(f) corresponds to the case where the number of rotation recognition marks 61 b is eight and the number of rotation recognition sensors 62b is one. The rotation recognition sensor 62b can detect a rotation state at every 45°. When the rotation recognition marks are densely arranged, the rotation state can be detected more accurately although the rotating speed of the susceptor is a relatively low speed.

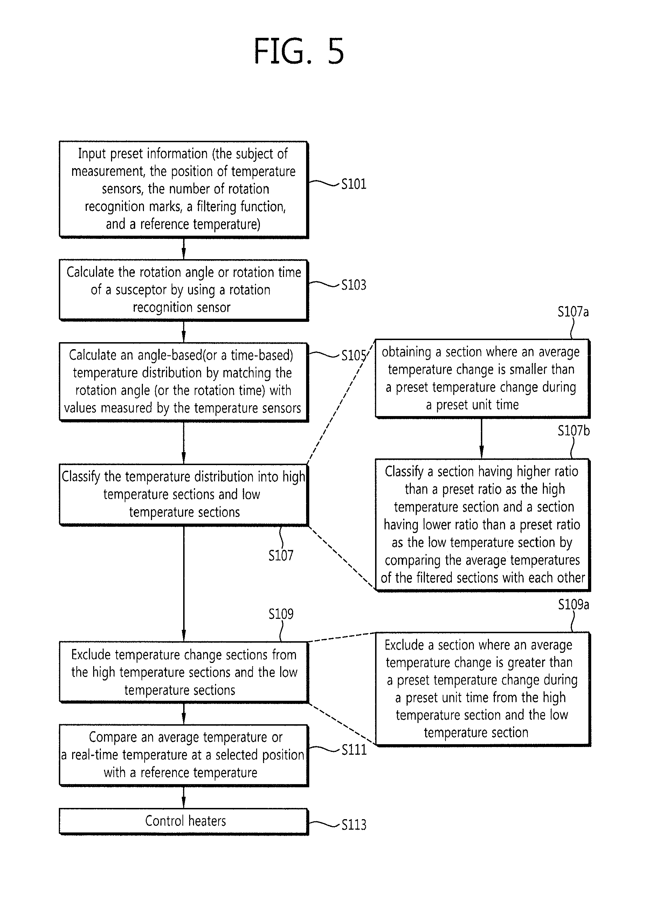

FIG. 5 is a flowchart of a temperature control method of the chemical vapor deposition device according to the present invention.

As shown in FIG. 5, first, a step of inputting preset information may be performed (S101). The preset information may include the subject of measurement, the position of the temperature sensors, the number of rotation recognition marks, a filtering function, a reference temperature, and so on.

Next, the rotation angle or rotation time of the susceptor may be calculated by using the rotation recognition sensor (S103). For example, when the number of rotation recognition marks is 4, the shaft rotates by 90° during a cycle where the rotation recognition marks are detected, and thus the rotating speed can be checked. Accordingly, the rotation angle during a lapse of time can be calculated.

Next, an angle-based temperature distribution (or a time-based temperature distribution) may be calculated by matching the rotation angle (or the rotation time) with values measured by the temperature sensors (S105).

Next, the temperature distribution may be classified into high temperature sections and low temperature sections by using the filtering function (S107), and a step of excluding temperature change sections from the high temperature sections and the low temperature sections may be performed (S109). The temperature change section refers to a section where temperature is consecutively changed at the edge portions of the wafers.

A method of classifying the temperature distribution into the high temperature sections and the low temperature sections may be various. For example, an average temperature may be calculated, and a section with temperature higher than the calculated average temperature may be classified as the high temperature section and a section with temperature lower than the calculated average temperature may be classified as the low temperature section.

Alternatively, if a specific temperature is repeatedly measured within a preset error range, a high temperature part of the specific temperature may be classified as the high temperature section and a low temperature part of the specific temperature may be classified as the low temperature section.

For another example, first, a section where an average temperature change is smaller than a preset temperature change during a preset unit time may be obtained (S107a).

A section having higher ratio than a preset ratio may be classified as the high temperature section and a section having lower ratio than a preset ratio may be classified as the low temperature section by comparing the average temperatures of the filtered sections with each other (S107b). In this case, the result that the temperature change sections have been excluded from the high temperature section and the low temperature section can be obtained.

A method of performing the step S109 may be various. For example, a method of excluding a section in which the amount of an average temperature change is greater than the amount of a preset temperature change during a preset unit time from the high temperature section and the low temperature section may be performed (S109a).

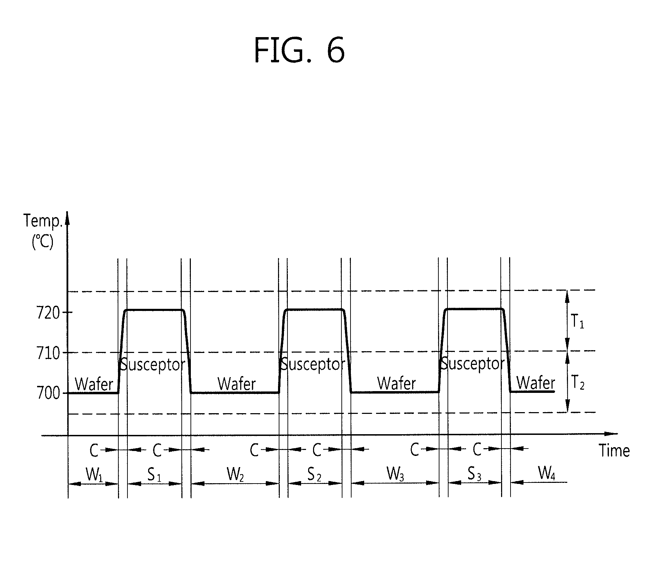

FIG. 6 is a graph showing an example of values measured by temperature sensors according to a lapse of time.

As shown in FIG. 6, in general, temperatures in wafer sections W1, W2, W3, and W4 are lower than temperatures in susceptor sections S1, S2, and S3. A temperature change section C in which temperature is not constant appears at the edges of the wafer. For example, a section having a relatively high temperature of 710°C or higher is indicated by T1, and a section having a relatively low temperature of 710°C or lower is indicated by T2. The sections W1, W2, W3, and W4 from which the temperature change sections C have been excluded may be classified as the wafer sections, and the sections S1, S2, and S3 from which the temperature change sections C have been excluded may be classified as the susceptor sections.

Referring back to FIG. 5, after the step S109, an average temperature or a real-time temperature at a selected position may be compared with a reference temperature (S111), and a step (S113) of controlling the heaters by taking the result of the comparison into consideration may be performed.

The selected position may be a top surface of the wafer, may be a surface of the susceptor between the wafer and the wafer, or may be a position on the straight line which connects the rotating shaft of the susceptor and the position of the rotation recognition mark.

As shown in FIG. 6, for example, a target position at which temperature will be controlled may be selected from among the sections W1, W2, W3, W4, S1, S2, and S3, and the temperature at the target position may be compared with a preset reference temperature. If, as a result of the comparison, the temperature at the target position is low, the amount of electric power supplied to the heaters may be increased. If, as a result of the comparison, the temperature at the target position is high, the amount of electric power supplied to the heaters may be decreased.

An embodiment of the present invention described above and shown in the drawings should not be interpreted as limiting the technical spirit of the present invention. The scope of the present invention is restricted by only the writing of the claims, and a person having ordinary skill in the art to which the present invention pertains may modify and change the technical spirit of the present invention in various forms. Accordingly, the modification and change may fall within the scope of the present invention as long as they are evident to those skilled in the art.

## Claims

1. A chemical vapor deposition device, comprising:
a chamber;
a susceptor rotatably placed within the chamber and configured to have wafers loaded on its upper surface;
a gas supplier provided within the chamber and configured to spray gas toward the wafers;
heaters provided within the susceptor and configured to heat the wafers;
a temperature sensor provided at an upper portion of the chamber and configured to measure a temperature at an upper surface of the susceptor;
a rotation recognition mark provided to be integrally rotated along with the susceptor;
a rotation recognition sensor provided in the chamber and configured to detect the rotation recognition mark in order to determine a rotation state of the susceptor; and
a controller configured to calculate a temperature distribution at an upper portion of the susceptor by using the rotation recognition sensor and the temperature sensor and to control the heaters based on the temperature distribution.

2. The chemical vapor deposition device as claimed in claim 1, wherein:
the heaters comprises a plurality of individual heaters arranged to form a concentric circle around a rotating shaft of the susceptor, and
the controller individually controls the individual heaters.

3. The chemical vapor deposition device as claimed in claim 1, wherein the temperature sensor is configured to be plural in order to check a temperature distribution for different positions in the susceptor.

4. The chemical vapor deposition device as claimed in claim 1, wherein the rotation recognition mark comprises at least one of a concave part, a convex part, and a reflection unit.

5. The chemical vapor deposition device as claimed in claim 1, wherein a plurality of the rotation recognition marks or the rotation recognition sensors is radially provided around a rotating shaft of the susceptor so that a detection cycle for the rotation recognition marks is reduced.

6. The chemical vapor deposition device as claimed in claim 1, wherein the temperature distribution is obtained by calculating a rotation angle or rotation time of the susceptor by using the rotation recognition sensor and,
the temperature distribution is an angle-based temperature distribution or an time-based temperature distribution calculated by matching the calculated rotation angle or rotation time with the measured values of the temperature sensors.

7. A temperature control method of a chemical vapor deposition device, comprising a chamber, a susceptor rotatably placed within the chamber and configured to have wafers loaded on its upper surface, a gas sprayer provided within the chamber and configured to spray gas toward the wafers, heaters provided within the susceptor and configured to heat the wafers, temperature sensors provided at an upper portion of the chamber and configured to measure a temperature at an upper portion of the susceptor, a rotation recognition mark provided at the susceptor or a rotating shaft of the susceptor to be integrally rotated along with the susceptor, and a rotation recognition sensor provided in the chamber in order to determine a rotation state of the susceptor and configured to detect the rotation recognition mark, wherein the temperature control method comprising the steps of:
(a) calculating a temperature distribution of the susceptor by using the rotation recognition sensor and the temperature sensors; and
(b) controlling the heaters based on the temperature distribution.

8. The temperature control method as claimed in claim 7, further comprising the step of inputting at least one of a subject of measurement, position information about the temperature sensors, position information about the rotation recognition mark, and a reference temperature to be used for temperature control, before the step (b).

9. The temperature control method as claimed in claim 7, wherein the step (a) comprises the steps of:
(a1) calculating a rotation angle or a rotation time of the susceptor by using the rotation recognition sensor; and
(a2) calculating an angle-based temperature distribution or a time-based temperature distribution by matching the calculated rotation angle or rotation time with the measured values of the temperature sensors.

10. The temperature control method as claimed in claim 7, wherein the step (b) includes classifying the temperature distribution into relatively high temperature sections and relatively low temperature sections by using a preset filtering function and controlling the heaters based on the high temperature sections or the low temperature sections.

11. The temperature control method as claimed in claim 10, wherein the step (b) includes controlling the heaters by comparing an average temperature or a real-time temperature at a position, selected from the high temperature sections or the low temperature sections, with a preset reference temperature.

12. The temperature control method as claimed in claim 10, wherein the step (b) includes filtering the temperature distribution by obtaining sections which an average temperature change during a preset unit time is smaller than a preset temperature change during a preset unit time from the temperature distribution and,
comparing average temperatures in the filtered sections and classifying a section having higher ratio than a preset ratio as the high temperature section and a section having lower ratio than a preset ratio as the low temperature section.

13. The temperature control method as claimed in claim 10, wherein the high temperature sections and the low temperature sections are sections from which temperature change sections, appearing when temperature is changed at edge portions of the wafers, have been filtered.

14. The temperature control method as claimed in claim 13, wherein a section in which an average temperature change is greater than a preset temperature change during a preset unit time is determined as the temperature change section and the temperature change section is filtered from the high temperature section and the low temperature section.

15. The temperature control method as claimed in claim 10, wherein the high temperature section is matched with a susceptor section, the low temperature section is matched with a wafer section, and the heaters are controlled based on the susceptor section or the wafer section selected by a user.
